# FASCICULE DE BREVET EUROPEEN

(11) **EP 3 408 620 B1**
(45) Date de publication et mention de la délivrance du brevet: **07.10.2020**
(21) Numéro de dépôt: 17701677.1
(22) Date de dépôt: 23.01.2017
(51) Int. Cl.: G01D 5/20, G01D 5/244, G01D 4/00

(54) **PROCÉDÉ DE COMPTAGE DE TOURS D'UNE ROUE, COMPTEUR DE CONSOMMATION ET PROGRAMME D'ORDINATEUR CORRESPONDANTS AINSI QUE MOYENS DE STOCKAGE D'UN TEL PROGRAMME**
VERFAHREN ZUM ZÄHLEN DER UMDREHUNGEN EINES RADES, ENTSPRECHENDER VERBRAUCHSZÄHLER UND COMPUTERPROGRAMM, SOWIE SPEICHERMEDIUM, AUF DEM EIN SOLCHES PROGRAMM GESPEICHERT IST
METHOD OF COUNTING WHEEL REVOLUTIONS, CORRESPUNDING UTILITY COUNTER AND COMPUTER PROGRAM, AS WELL AS STORAGE MEANS STORING SUCH A PROGRAM

(30) Priorité: 25.01.2016 FR 1650571
(43) Date de publication de la demande: 05.12.2018
(73) Titulaire: Sagemcom Energy & Telecom SAS, 92500 Rueil-Malmaison (FR)
(72) Inventeur: TEBOULLE, Henri, 92500 Rueil-Malmaison (FR)
(74) Mandataire: Lavaud, Thomas
(86) Numéro de dépôt international: PCT/EP2017/051285
(87) Numéro de publication internationale: WO 2017/129508

(56) Documents cités:
- EP-A1- 0 311 129
- EP-A1- 0 408 084
- "Low Energy Sensor AN0029 -Application Note", , 16 septembre 2013 (2013-09-16), pages 1-23, XP055175561, Austin, TX 78701, US Extrait de l'Internet: URL:http://www.silabs.com/Support Documents/TechnicalDocs/AN0029.pdf [extrait le 2015-03-11]

## Description

La présente invention concerne le comptage de tours d'une roue, par exemple dans le domaine des compteurs mécaniques tels que ceux utilisés pour la distribution de gaz ou d'eau.

### ARRIERE PLAN DE L'INVENTION

Il est connu un compteur de gaz comprenant une roue tournant autour d'un axe par rapport à un bâti de telle manière que la vitesse de rotation de la roue soit représentative de la quantité de gaz distribué.

Le compteur de gaz comporte un dispositif de comptage du nombre de tours de la roue. Le dispositif de comptage comprend classiquement une cible, un dispositif de détection de la cible, et une unité de comptage.

Ainsi, il est connu un dispositif de comptage dans lequel la cible est un aimant excentré fixé à la roue, et dans lequel le dispositif de détection comprend un relais magnétique de type ampoule REED, monté fixe par rapport au bâti. L'unité de comptage est reliée au relais magnétique pour détecter le passage de l'aimant et ainsi compter le nombre de tours.

Il est connu également un dispositif de comptage dans lequel la cible est une pièce métallique, et dans lequel le dispositif de détection comprend une bobine d'un circuit résonant. L'unité de comptage est alors reliée au circuit résonant pour détecter le passage de la pièce métallique et ainsi compter le nombre de tours.

Le document EP 0 408 084 A1 décrit un compteur comprenant un tel dispositif de comptage.

La conception d'un tel dispositif de comptage doit être conforme à des exigences très strictes en matière de précision de comptage. La dérive acceptable spécifiée pour certains compteurs de gaz modernes est ainsi typiquement inférieure ou égale à un tour tous les dix mille tours.

Or, la roue du compteur de gaz et le dispositif de détection de la cible sont soumis à de multiples contraintes qui tendent à perturber le comptage : dérives mécaniques dues par exemple à des vibrations, phénomènes d'usure provoquant un voilage de la roue, vieillissement des composants, variations de température, etc.

L'unité de comptage du dispositif de comptage est elle aussi soumise à de multiples contraintes. Les composants électriques de l'unité de comptage sont en particulier soumis à des perturbations radioélectriques et à des perturbations de leur tension d'alimentation.

Les perturbations radioélectriques résultent notamment de l'émission, par le compteur de gaz ou dans l'environnement du compteur de gaz, d'ondes radioélectriques destinées à la transmission de données via une communication sans fil. Les données transmises sont par exemple des données relatives à la quantité de gaz distribué. La communication sans fil est par exemple une communication sans fil de type RFID (pour « Radio-Frequency IDentification ») ou NFC (pour « Near Field Communication ») .

Les perturbations d'alimentation résultent notamment d'un appel de courant transitoire susceptible de survenir au moment de chaque démarrage de l'unité de comptage (qui est maintenue en veille la plupart du temps), ledit appel de courant provoquant une baisse de la tension d'alimentation de courte durée mais relativement significative.

L'ensemble de ces contraintes et perturbations tend à réduire la précision du comptage.

### OBJET DE L'INVENTION

L'invention a pour objet d'améliorer la précision du comptage de tours d'une roue sans pour autant augmenter de manière importante le coût ou la complexité de la mise en œuvre dudit comptage.

### RESUME DE L'INVENTION

En vue de la réalisation de ce but, on propose un procédé de comptage de tours d'une roue sur laquelle est fixée une cible, le procédé de comptage comportant les étapes, répétées à intervalles de détection réguliers :
- de générer un signal de tension oscillant représentatif de la présence ou de l'absence de la cible ;
- de comparer une amplitude du signal de tension oscillant avec un seuil de tension prédéterminé pour obtenir des impulsions ;
- de détecter une présence de la cible ou une absence de la cible en fonction du nombre d'impulsions obtenues.

Selon l'invention, le procédé de comptage comporte en outre une étape de détection d'une perturbation susceptible d'affecter une détection de la cible, l'étape de détection étant mise en œuvre de manière rétroactive et consistant à acquérir des valeurs d'impulsions différentielles égales chacune à une différence entre deux nombres d'impulsions obtenues au cours de deux intervalles de détection successifs, et à détecter une perturbation à partir d'une identification d'une séquence erronée d'impulsions différentielles successives.

La détection des perturbations susceptibles d'affecter la détection de la cible permet de corriger le nombre d'impulsions obtenues au cours de ces perturbations et donc d'améliorer la détection de la cible et la précision du comptage.

Le procédé de comptage selon l'invention améliore donc la précision du comptage en corrigeant l'effet des perturbations grâce à l'analyse de données disponibles (les valeurs d'impulsions différentielles), et ne nécessite pas d'ajouter des composants « hardware » pour améliorer la précision de la détection de la cible. La complexité et le coût de la mise en œuvre du procédé de comptage selon l'invention sont donc réduits.

D'autres caractéristiques et avantages de l'invention ressortiront à la lecture de la description qui suit d'un mode de réalisation particulier, non limitatif de l'invention.

### BREVE DESCRIPTION DES DESSINS

Il sera fait référence aux dessins annexés parmi lesquels :
- la figure 1 est une vue schématique et en perspective d'un compteur de gaz dans lequel est mis en œuvre le procédé de comptage de tours d'une roue selon l'invention ;
- la figure 2 représente la roue dans une certaine position, avec l'allure d'un signal de tension oscillant produit par des circuits inductifs d'un dispositif de comptage du compteur ;
- les figures 3 à 5 sont des vues analogues à la figure 2, pour d'autres positions de la roue ;
- la figure 6 est un schéma électrique du dispositif de comptage ;
- la figure 7 est un graphique qui comporte une courbe d'un signal de tension oscillant ainsi que des impulsions générées à partir du signal de tension oscillant alors qu'une présence d'une cible située sur la roue est détectée ;
- la figure 8 est une figure analogue à la figure 7, alors qu'une absence de la cible est détectée.

### DESCRIPTION DETAILLEE DE L'INVENTION

L'invention est ici décrite en application à un compteur de gaz destiné à être installé dans un bâtiment privé pour raccorder une installation de distribution du gaz dans le bâtiment à un réseau externe de distribution du gaz. Il va de soi que l'invention n'est pas limitée à cette application et concerne aussi, notamment, les compteurs d'eau, d'électricité...

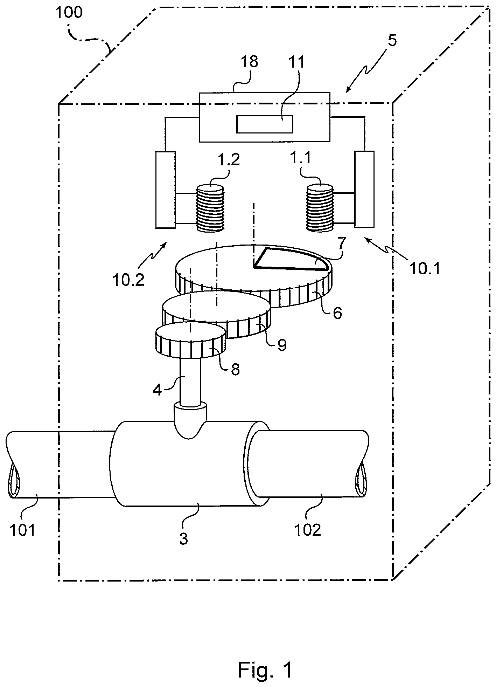

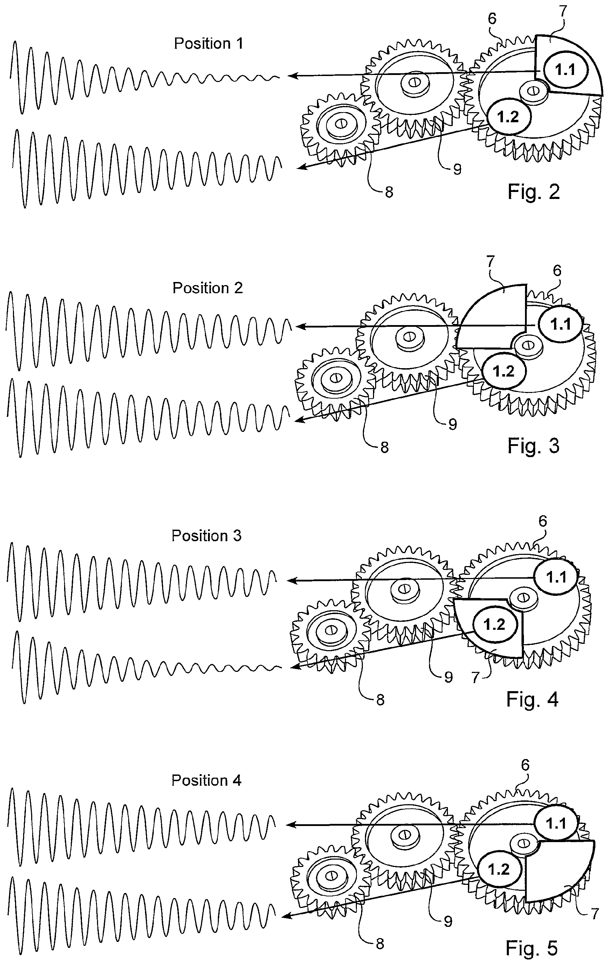

En référence aux figures 1 à 5, le compteur de gaz comprend un bâti formant boîtier 100 dans lequel arrive un conduit 101 d'amenée de gaz, relié au réseau externe de distribution, et dont part un conduit 102 de l'installation de distribution de gaz. Les deux conduits sont reliés l'un à l'autre par un raccord 3 dans lequel s'étend une partie d'un élément tournant 4 entrainée en rotation par le gaz circulant dans le raccord depuis le conduit 101 vers le conduit 102 de telle manière que la rotation de l'élément tournant 4 soit représentative de la quantité de gaz passant dans le raccord 3.

Une roue 6 en matériau non métallique est liée en rotation à l'élément tournant 4. La roue 6 est pourvue d'une denture périphérique et un premier pignon denté 8 est solidaire de l'élément tournant 4 pour transmettre le mouvement de l'élément tournant 4 vers la roue 6 via un deuxième pignon denté 9 engrenant avec la roue 6 et le premier pignon 8. Les pignons 8, 9 et la roue 6 ont des diamètres tels que la roue 6 ait une fréquence de rotation inférieure à une fréquence de rotation du premier pignon 8. La roue 6 tourne ici deux fois moins vite que le premier pignon 8.

Le compteur de gaz comprend un dispositif de comptage des tours de la roue 6, généralement désigné en 5.

Le dispositif de comptage 5 comprend tout d'abord une cible 7, qui est une masse métallique excentrée positionnée sur la roue 6. La cible 7 occupe ici un quartier de la roue 6.

Le dispositif de comptage 5 comprend de plus un premier dispositif de détection comportant un premier circuit inductif résonant 10.1, et un deuxième dispositif de détection comportant un deuxième circuit inductif résonant 10.2.

Le dispositif de comptage 5 comprend également une unité de comptage 18 comportant ici un microcontrôleur 11. Le premier circuit inductif résonant 10.1 et le deuxième circuit inductif résonant 10.2 sont reliés à l'unité de comptage 18.

Chaque circuit inductif résonant 10.1, 10.2 comprend une bobine 1.1, 1.2 montée fixe par rapport au boîtier 100 en regard chacune d'une portion de trajectoire de la cible 7. Les bobines 1.1, 1.2 sont écartées l'une de l'autre de manière que chaque bobine 1 soit sensible successivement à la cible 7, c'est-à-dire que lorsque l'une des bobines 1.1, 1.2 est soumise à l'influence de la cible 7, l'autre des bobines 1.1, 1.2 ne l'est pas.

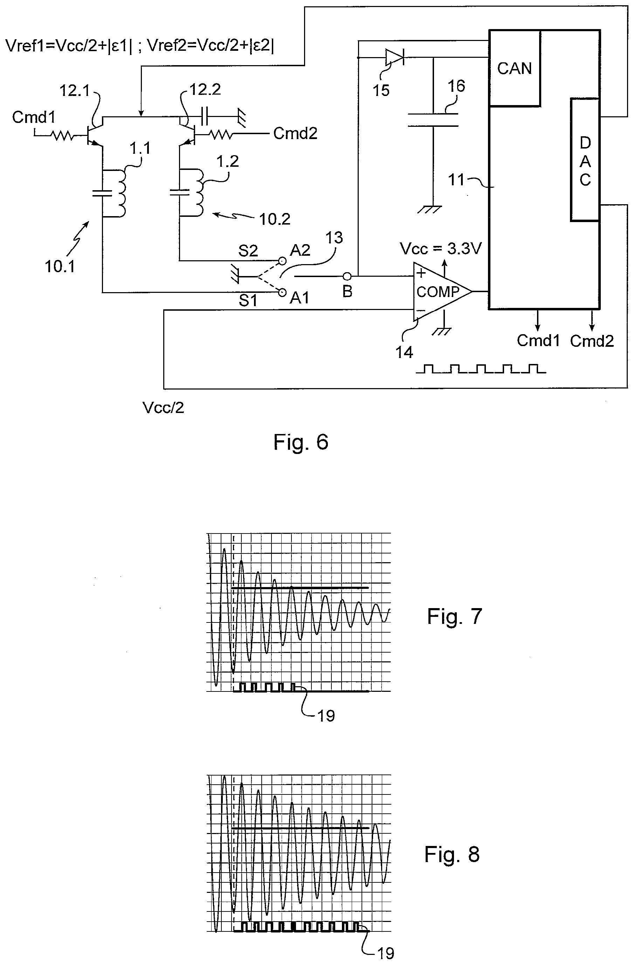

En référence à la figure 6, chaque bobine 1 a une extrémité haute reliée à un convertisseur numérique analogique DAC du microcontrôleur 11 par des commutateurs 12.1, 12.2 et une extrémité basse reliée à une borne A1, A2 d'un commutateur 13 ayant une troisième borne reliée à la masse et une quatrième borne B reliée à un entrée non-inverseuse d'un comparateur 14. Le comparateur 14 a une entrée inverseuse reliée au convertisseur numérique analogique DAC du microcontrôleur 11 et une sortie reliée à une entrée du microcontrôleur 11. Le microcontrôleur 11 intègre un mécanisme permettant de compter les fronts montants (on pourrait également compter les fronts descendants au lieu des fronts montants) en sortie du comparateur 14. La forme d'onde du signal en sortie du comparateur 14 est un signal impulsionnel rectangulaire, par exemple à 3,3V.

La borne B du commutateur 13 est reliée via une diode 15 à un convertisseur analogique numérique CAN du microcontrôleur 11. Un condensateur 16 est monté entre la cathode de la diode 15 et la masse pour former un détecteur d'enveloppe du signal arrivant par la borne B du commutateur 13.

Le microcontrôleur 11 pilote les transistors 12.1, 12.2 entre leurs états passant et bloquant au moyen de signaux de commande Cmd1, Cmd2.

L'unité de comptage 18 est agencée pour mettre en œuvre le procédé de comptage selon l'invention, qui comporte les étapes suivantes, répétées à intervalles de détection réguliers :
- émettre quasi simultanément en entrée de chaque circuit inductif 10.1, 10.2 une impulsion de tension Vref1, Vref2 d'amplitude prédéterminée de manière à générer un signal de tension oscillant S1, S2 en sortie du circuit inductif 10.1, 10.2 ;
- détecter le signal de tension oscillant S1, S2 en sortie du circuit inductif 10.1, 10.2 et comparer l'amplitude du signal de tension oscillant S1, S2 avec un seuil de tension prédéterminé Vcc/2 ;
- détecter une présence de la cible 7 lorsque le nombre d'impulsions obtenues est inférieur ou égal à un seuil inférieur prédéterminé (cas de la figure 7), et détecter une absence de la cible 7 lorsque le nombre d'impulsions obtenues est supérieur ou égal à un seuil supérieur prédéterminé (cas de la figure 8) ;
- incrémenter d'un un nombre de tours mémorisé après avoir détecté deux fois successivement la présence de la cible 7.

On comprend que chaque circuit inductif 10.1, 10.2 amortit l'impulsion de tension et fournit un signal de tension oscillant. Selon que la cible 7 est présente ou non sous la bobine 1.1, 1.2, l'amortissement procuré par chaque circuit inductif 10.1, 10.2 est modifié.

L'émission de l'impulsion de tension Vref1, Vref2 en entrée de chaque circuit inductif 10.1, 10.2 est réalisée de la manière suivante.

Les transistors 12.1, 12.2 sont initialement à l'état bloquant et le commutateur 13 maintient les deux bobines 1.1, 1.2 à la masse.

A l'instant t=tn, la bobine 1.1 est excitée par l'injection de l'impulsion de tension Vref1. A cette fin, le transistor 12.1 est amené dans son état passant et, après 2µs (la capacité de la bobine 1.1 est alors chargée), le commutateur 13 est commandé pour relier la bobine 1.1 à l'entrée positive du comparateur 14 et lui fournir le signal S1. A t=tn+t0, le nombre d'impulsions est déterminé.

Lorsque la bobine 1.1 est excitée, la bobine 1.2 est découplée autant que possible du reste du premier dispositif de comptage. L'extrémité basse de la bobine 1.2 est mise à la masse à cet effet via le commutateur 13, et l'extrémité haute de la bobine 1.2 est portée à haute impédance via le commutateur 12.2.

A l'instant t=tn+50µs, la bobine 1.2 est excitée par l'injection de l'impulsion de tension Vref2. A cette fin, le transistor 12.2 est amené dans son état passant et, après 2µs (la capacité de la bobine 1.2 est alors chargée), le commutateur 13 est commandé pour relier la bobine 1.2 à l'entrée positive du comparateur 14 et lui fournir le signal S2. A t=tn+50µs+t0, le nombre d'impulsions est déterminé.

Lorsque la bobine 1.2 est excitée, la bobine 1.1 est découplée autant que possible du reste du premier dispositif de comptage. L'extrémité basse de la bobine 1.1 est mise à la masse à cet effet via le commutateur 13, et l'extrémité haute de la bobine 1.1 est portée à haute impédance via le commutateur 12.1.

Le seuil supérieur prédéterminé du nombre d'impulsions obtenues permettant de détecter l'absence de la cible est ici égal à 17, et le seuil inférieur prédéterminé du nombre d'impulsions obtenues permettant de détecter la présence de la cible est ici égal à 14.

La tension respective des impulsions Vref1 et Vref2, ajustée au préalable (en usine par exemple), est légèrement supérieure au seuil de tension prédéterminé Vcc/2 et est ici égale respectivement à Vcc/2+|ε1| et Vcc/2+|ε2|. Cet ajustement permet de régler le nombre nominal d'impulsions obtenues en présence et en l'absence de la cible 7 dans des conditions nominales de fabrication et de fonctionnement (conditions de température, etc.).

Ici, l'ajustement est réalisé de sorte que le nombre nominal d'impulsions obtenues soit égal à 11 lorsqu'une présence de la cible est détectée et à 20 lorsqu'une absence de la cible est détectée.

On note que, pour chaque dispositif de détection et à chaque intervalle de détection, lorsque le nombre d'impulsions obtenues est supérieur à 17 (c'est-à-dire au seuil supérieur prédéterminé), on force « artificiellement » le nombre d'impulsions obtenues à 17, et lorsque le nombre d'impulsions obtenues est inférieur à 14 (c'est-à-dire au seuil inférieur prédéterminé), on force artificiellement le nombre d'impulsions obtenues à 14. On simplifie ainsi le comptage de tours en limitant les variations du nombre d'impulsions obtenues.

Les intervalles de détection réguliers sont ici égaux à 143ms, ce qui correspond à une fréquence d'échantillonnage de 7Hz.

Comme cela a été dit plus tôt, un certain nombre de contraintes et de perturbations sont susceptibles d'affecter la détection de la cible 7, et donc le comptage de tours de la roue 6.

Parmi ces perturbations, certaines perturbations ont pour effet d'augmenter ou de réduire l'amplitude du signal de tension oscillant en sortie de chaque circuit inductif 10.1, 10.2.

C'est par exemple le cas de perturbations « mécaniques » qui tendent à déformer la roue 6 et qui éloignent ou rapprochent les bobines 1.1, 1.2 de la roue 6 et donc de la cible 7.

C'est aussi et surtout le cas de perturbations d'alimentation qui ont pour conséquence une augmentation ou une baisse de la tension d'alimentation de l'unité de comptage 18. L'impact d'une telle augmentation ou baisse d'alimentation est plus important sur la tension respective des impulsions Vref1 et Vref2 (et donc sur l'amplitude des signaux de tension oscillant) que sur le seuil de tension prédéterminé Vcc/2.

Dans les deux exemples de perturbations qui viennent d'être évoqués, le nombre d'impulsions obtenues en sortie du comparateur 14 est modifié par rapport à ce qu'il devrait être en l'absence de perturbations. Il existe donc un risque de détecter une absence de la cible 7 alors que celle-ci est présente, ou une présence de la cible 7 alors que celle-ci est absente, et donc de compter un tour de la roue 6 alors que celle-ci n'a pas tourné (ou, tout au moins, alors que la roue 6 n'a pas effectué un tour complet). Une telle situation est bien sûr inacceptable pour le consommateur, qui peut voir sa consommation de gaz mesurée augmenter alors que celle-ci n'a en réalité pas évolué.

Le procédé de comptage selon l'invention comporte une étape de détection d'une telle perturbation.

L'étape de détection consiste, pour chaque dispositif de détection considéré indépendamment et donc pour chaque bobine 1.1, 1.2 considérée indépendamment, à acquérir des valeurs d'impulsions différentielles égales chacune à une différence entre deux nombres d'impulsions obtenues au cours de deux intervalles de détection successifs, et à détecter une perturbation à partir d'une identification d'une séquence erronée d'impulsions différentielles successives.

Les séquences analysées d'impulsions différentielles successives ont une longueur comprise entre une première longueur minimale prédéterminée et une première longueur maximale prédéterminée (c'est à dire que chaque séquence analysée comporte au minimum un nombre d'impulsions différentielles successives égal à la première longueur minimale prédéterminée et au maximum un nombre d'impulsions différentielles successives égal à la première longueur maximale prédéterminée). Ici, la première longueur minimale prédéterminée est égale à 2 et la première longueur maximale prédéterminée est égale à 9.

On illustre la notion d'« impulsions différentielles successives » en utilisant trois exemples de séquences de nombres d'impulsions produites par l'un des dispositifs de détection (et donc l'une des bobines 1.1, 1.2).

La séquence de nombres d'impulsions :
.../17/16/16/17/17/17/17/...
correspond à l'obtention, pour un dispositif de détection et pour une bobine 1 donnés, de 17 impulsions pendant un intervalle de détection, puis de 16 impulsions pendant deux intervalles de détection, puis de 17 impulsions pendant quatre intervalles de détection, chaque intervalle de détection ayant une durée de 143ms. L'absence de la cible 7 est ainsi détectée pendant sept intervalles de détection de 143ms.

La séquence d'impulsions différentielles successives correspondante est la suivante :
.../-1/0/1/0/0/0/...,
que l'on notera ici pour simplifier -1/0/1/0/0/0.

De même, la séquence de nombres d'impulsions :
14/14/14/15/14/14/14
correspond à l'obtention, pour un dispositif de détection et pour une bobine 1 donnés, de 14 impulsions pendant trois intervalles de détection, puis de 15 impulsions pendant un intervalle de détection, puis de 14 impulsions pendant trois intervalles de détection, chaque intervalle de détection ayant une durée de 143ms. La présence de la cible 7 est ainsi détectée pendant sept intervalles de détection de 143ms.

La séquence d'impulsions différentielles successives correspondante est la suivante :
0/0/1/-1/0/0.

La séquence de nombres d'impulsions :
14/14/15/16/17/17/17
correspond à l'obtention, pour un dispositif de détection et pour une bobine 1 donnés, de 14 impulsions pendant deux intervalles de détection, puis de 15 impulsions pendant un intervalle de détection, puis de 16 impulsions pendant un intervalle de détection, puis de 17 impulsions pendant trois intervalles de détection, chaque intervalle de détection ayant une durée de 143ms.

La présence puis l'absence de la cible 7 sont ainsi détectées, ce qui signifie que la roue 6 a tourné.

La séquence d'impulsions différentielles successives correspondante est la suivante :
0/1/1/1/0/0.

Les séquences qui viennent d'être présentées sont des séquences valides de nombres d'impulsions et d'impulsions différentielles successives.

Des exemples de séquences erronées d'impulsions différentielles successives sont maintenant présentés.

Ainsi, la séquence suivante est une première séquence erronée d'impulsions différentielles successives :
-1/2/0/-1.

Les impulsions différentielles successives de la première séquence erronée d'impulsions différentielles successives sont obtenues aux temps respectifs :
8787,286s ;
8787,429s ;
8787,571s ;
8787,714s.

Des impulsions différentielles extérieures à la première séquence erronée d'impulsions différentielles successives et adjacentes aux bornes de la première séquence erronée d'impulsions différentielles successives sont nulles (c'est à dire qu'une impulsion différentielle égale à 0 est obtenue au temps 8787,143s et qu'une impulsion différentielle égale à 0 est obtenue au temps 8787, 857s) .

On note que l'intervalle de temps entre deux impulsions différentielles successives est bien égal à un intervalle de détection, soit à 143ms.

La première séquence erronée d'impulsions différentielles successives résulte d'une baisse de l'amplitude du signal de tension oscillant en sortie du circuit inductif 10 et donc d'un nombre d'impulsions obtenues erroné, ledit nombre d'impulsions obtenues erroné produisant des valeurs d'impulsions différentielles erronées.

De même, la séquence suivante est une deuxième séquence erronée d'impulsions différentielles successives :
-2/2.

Les impulsions différentielles successives de la deuxième séquence erronée d'impulsions différentielles successives sont obtenues aux temps respectifs : 17637,857s ;
17638,000s.

Des impulsions différentielles extérieures à la deuxième séquence erronée d'impulsions différentielles successives et adjacentes aux bornes de la deuxième séquence erronée d'impulsions différentielles successives sont nulles (c'est à dire qu'une impulsion différentielle égale à 0 est obtenue au temps 17637,714s et qu'une impulsion différentielle égale à 0 est obtenue au temps 17638,143s) .

De même, la séquence suivante est une troisième séquence erronée d'impulsions différentielles successives :
-1/1/1/-1/1/-2/1/1/-1.

Les impulsions différentielles successives de la troisième séquence erronée d'impulsions différentielles successives sont obtenues aux temps respectifs :
19873,429s ;
19873,571s ;
19873,714s ;
19873,857s ;
19874,000s ;
19874,143s ;
19874,286s ;
19874,429s ;
19874,571s.

On note que des impulsions différentielles extérieures à la troisième séquence erronée d'impulsions différentielles successives et adjacentes aux bornes de la troisième séquence erronée d'impulsions différentielles successives sont nulles (c'est à dire qu'une impulsion différentielle égale à 0 est obtenue au temps 19873.286ms et qu'une impulsion différentielle égale à 0 est obtenue au temps 19874,714s).

L'identification d'une séquence erronée d'impulsions différentielles successives est réalisée de la manière suivante.

Une séquence donnée d'impulsions différentielles successives est identifiée comme étant une séquence erronée si :
- une somme des valeurs des impulsions différentielles constituant la séquence donnée est nulle, et
- si des bornes de la séquence donnée sont non nulles, et
- si des impulsions différentielles extérieures à la séquence en question et adjacentes aux bornes de la séquence donnée sont nulles.

Alternativement, on considère qu'une séquence donnée d'impulsions différentielles successives est erronée si, en plus des critères ci-dessus, cette séquence donnée d'impulsions différentielles successives comporte au plus une impulsion différentielle de valeur nulle.

Les première, deuxième et troisième séquences erronées d'impulsions différentielles successives ci-dessus remplissent bien les critères énoncés.

Le procédé de comptage selon l'invention comporte en outre une étape de détection de rotation effective permettant de détecter une rotation effective de la roue 6 à l'intérieur de la séquence erronée d'impulsions différentielles successives. Il est bien sûr effectivement possible que la roue 6 soit en train de tourner lorsqu'une perturbation se produit.

L'étape de détection de rotation effective est ici uniquement mise en œuvre sur des séquences erronées d'impulsions différentielles successives de longueur supérieure ou égale à une deuxième longueur minimale prédéterminée. Ici, la deuxième longueur minimale prédéterminée est égale à 4.

On note dès à présent que, lorsqu'une séquence erronée d'impulsions différentielles successives de longueur inférieure à la deuxième longueur minimale prédéterminée est détectée, l'étape de détection de rotation effective n'est pas mise en œuvre et l'ensemble des impulsions différentielles de la séquence erronée sont mises à zéro. La séquence de nombres d'impulsions obtenues correspondante est ensuite exploitée pour le comptage des tours de la roue 6.

L'étape de détection de rotation effective consiste, pour la séquence erronée d'impulsions différentielles successives :
- à classer dans une première catégorie les impulsions différentielles ayant une valeur absolue supérieure ou égale à un premier seuil de valeur prédéterminé ;
- à classer dans une deuxième catégorie les impulsions différentielles ayant une valeur absolue supérieure ou égale à un deuxième seuil de valeur prédéterminé, le deuxième seuil de valeur prédéterminé étant inférieur au premier seuil de valeur prédéterminé ;
- à classer dans une troisième catégorie les impulsions différentielles ayant une valeur absolue inférieure ou égale à un troisième seuil de valeur prédéterminé, le troisième seuil de valeur prédéterminé étant inférieur au deuxième seuil de valeur prédéterminé ;
- parmi les impulsions différentielles de la première catégorie et de la deuxième catégorie, à identifier des impulsions différentielles valides qui sont de signes contraires et qui sont séparées, dans la séquence erronée, par au moins deux impulsions différentielles successives.

Ici, le premier seuil de valeur prédéterminé est égal à 3, le deuxième seuil de valeur prédéterminé est égal à 2, et le troisième seuil de valeur prédéterminé est égal à 1.

Puis, les impulsions différentielles valides de la séquence erronée d'impulsions différentielles successives sont mises à une valeur différentielle prédéterminée, et les autres impulsions différentielles de la séquence erronée d'impulsions différentielles successives sont mises à zéro.

La valeur différentielle prédéterminée est positive lorsque l'impulsion différentielle valide de la séquence erronée est positive et la valeur différentielle prédéterminée est négative lorsque l'impulsion différentielle valide de la séquence erronée est négative.

Ici, la valeur différentielle prédéterminée positive est égale à 2 et la valeur différentielle prédéterminée négative est égale à -2.

Pour illustrer l'étape de détection de rotation effective, on reprend les première, deuxième et troisième séquences erronées d'impulsions différentielles successives, et on étudie la forme de ces séquences erronées d'impulsions différentielles successives lorsqu'une rotation effective survient au cours de chacune de ces séquences erronées d'impulsions différentielles successives.

Dans le cas de la première séquence erronée d'impulsions différentielles successives, une rotation effective se traduit par une modification de la première séquence erronée d'impulsions différentielles successives :
-1/2/0/-1
qui devient, du fait de la rotation effective, une quatrième séquence erronée d'impulsions différentielles successives :
-2/-2/2/2.

On ne classe aucune impulsion différentielle dans la première catégorie (car aucune impulsion différentielle ne possède une valeur absolue supérieure ou égale à 3). On classe dans la deuxième catégorie la première, la deuxième, la troisième et la quatrième impulsion différentielle (de valeurs respectives -2, -2, 2 et 2). On ne classe aucune impulsion différentielle dans la troisième catégorie.

On identifie ensuite, dans la deuxième catégorie, des impulsions différentielles valides, qui sont de signes contraires et qui sont séparées, dans la séquence erronée, par au moins deux impulsions différentielles successives. C'est le cas de la première impulsion différentielle et de la quatrième impulsion différentielle.

Ces impulsions différentielles valides correspondent à une rotation effective de la roue 6 superposée à une perturbation. Il est donc pertinent de les prendre en compte pour le comptage de tours de la roue 6.

Les impulsions différentielles valides de la quatrième séquence erronée d'impulsions différentielles sont mises à la valeur différentielle prédéterminée adéquate : la première impulsion différentielle prend la valeur -2 et la quatrième impulsion différentielle prend la valeur 2. Les autres impulsions différentielles de la quatrième séquence erronée d'impulsions différentielles successives sont mises à zéro.

La quatrième séquence erronée d'impulsions différentielles successives devient donc :
-2/0/0/2.

L'impulsion différentielle -2 correspond à la transition entre une détection de l'absence et une détection de la présence de la cible 7 de la roue 6, et donc à une rotation effective de la roue 6. De même, l'impulsion différentielle 2 correspond à la transition entre une détection de la présence et une détection de l'absence de la cible 7 de la roue 6, et donc à une rotation effective de la roue 6.

Dans le cas de la deuxième séquence erronée d'impulsions différentielles successives, une rotation effective se traduit par une modification de la deuxième séquence erronée d'impulsions différentielles successives :
(0)/-2/2/(0)
qui devient, du fait de la rotation effective, une cinquième séquence erronée d'impulsions différentielles successives :
-4/0/2/2.

On note que la rotation effective impacte aussi les impulsions différentielles extérieures à la séquence et adjacentes aux bornes de la séquence.

On classe dans la première catégorie la première impulsion différentielle (en partant de la gauche ; de valeur -4). On classe dans la deuxième catégorie la troisième et la quatrième impulsion différentielle (de valeurs 2 et 2). On classe dans la troisième catégorie la deuxième impulsion différentielle (de valeur 0).

On identifie ensuite, dans la première catégorie et dans la deuxième catégorie, des impulsions valides, qui sont de signes contraires et qui sont séparées, dans la séquence erronée, par au moins deux impulsions différentielles successives. C'est le cas de la première impulsion différentielle et de la quatrième impulsion différentielle.

Ces impulsions différentielles valides correspondent à une rotation effective de la roue 6 superposée à une perturbation. Il est donc pertinent de les prendre en compte pour le comptage de tours de la roue 6.

Les impulsions différentielles valides de la cinquième séquence erronée d'impulsions différentielles successives sont mises à la valeur différentielle prédéterminée adéquate : la première impulsion différentielle prend la valeur -2 et la quatrième impulsion différentielle prend la valeur 2. Les autres impulsions différentielles de la cinquième séquence erronée d'impulsions différentielles successives sont mises à zéro.

La cinquième séquence erronée d'impulsions différentielles successives devient donc :
-2/0/0/2.

L'impulsion différentielle -2 correspond à la transition entre une détection de l'absence et une détection de la présence de la cible 7 de la roue 6, et donc à une rotation effective de la roue 6. De même, l'impulsion différentielle 2 correspond à la transition entre une détection de la présence et une détection de l'absence de la cible 7 de la roue 6, et donc à une rotation effective de la roue 6.

Dans le cas de la troisième séquence erronée d'impulsions différentielles successives, une rotation effective se traduit par une modification de la troisième séquence erronée d'impulsions différentielles successives :
-1/1/1/-1/1/-2/1/1/-1,
qui devient, du fait de la rotation effective, une sixième séquence erronée d'impulsions différentielles successives :
-1/1/-3/1/1/-2/3/1/-1.

On classe dans la première catégorie la troisième impulsion différentielle (en partant de la gauche ; de valeur -3) et la septième impulsion différentielle (de valeur 3). On classe dans la deuxième catégorie la sixième impulsion différentielle (de valeur -2). On classe dans la troisième catégorie la première, deuxième, quatrième, cinquième, huitième et neuvième impulsion différentielle (de valeurs respectives -1, 1, 1, 1, 1, -1).

On identifie ensuite, dans la première catégorie et dans la deuxième catégorie, des impulsions valides, de signes contraires et qui sont séparées, dans la séquence erronée, par au moins deux impulsions différentielles successives. C'est le cas de la troisième impulsion différentielle et de la septième impulsion différentielle.

Ces impulsions différentielles valides correspondent à une rotation effective de la roue 6 superposée à une perturbation. Il est donc pertinent de les prendre en compte pour le comptage de tours de la roue 6.

Les impulsions différentielles valides de la sixième séquence erronée d'impulsions différentielles successives sont mises à la valeur prédéterminée : la troisième impulsion différentielle prend la valeur -2 et la septième impulsion différentielle prend la valeur 2. Les autres impulsions différentielles de la séquence erronée sont mises à zéro.

La sixième séquence erronée d'impulsions différentielles devient donc :
0/0/-2/0/0/0/2/0/0.

On note que l'étape de détection de perturbation et l'étape de détection de rotation effective sont réalisées de manière rétroactive. La détection d'une perturbation et la détection d'une rotation consistent en effet à identifier des séquences erronées d'impulsions différentielles successives particulières résultant de nombres d'impulsions obtenues au cours d'intervalles de détection qui précèdent lesdites détections.

On met ainsi un œuvre un filtrage non linéaire par corrélation à effet rétroactif, qui permet d'éliminer de manière rétroactive les effets potentiellement néfastes des perturbations sur le comptage des tours de la roue 6.

Comme les informations de comptage sont remontées typiquement deux fois par jour par le compteur de gaz, la mise en œuvre de ce filtrage à effet rétroactif n'entraîne aucun retard de transmission d'informations de comptage (et donc de données de consommation de gaz).

Il est possible de prévoir d'effectuer l'étape de détection de rotation effective seulement si une vitesse de rotation de la roue 6 est supérieure à un seuil de vitesse prédéterminé. Typiquement, le seuil de vitesse prédéterminé est égal à 0,5 tours par seconde. En effet, lorsque la roue 6 tourne à une vitesse relativement importante, il est beaucoup plus probable qu'une rotation effective soit détectée lors de la survenue d'une perturbation. C'est le cas par exemple lorsque la roue 6 tourne à la vitesse de 1,2 tour par seconde.

Dans ce cas, lorsque l'étape de détection de rotation effective n'est pas mise en œuvre, toutes les impulsions différentielles de la séquence erronée d'impulsions différentielles sont mises à zéro.

Bien entendu, l'invention n'est pas limitée au mode de réalisation décrit mais englobe toute variante entrant dans le champ de l'invention telle que définie par les revendications.

Les seuils et les valeurs numériques utilisés dans la description ne sont fournis que pour illustrer l'invention et peuvent bien sûr être différents.

L'étape additionnelle de détection de rotation effective est bien sûr avantageuse, mais pas nécessaire. Il est en effet parfaitement possible de prévoir que, lorsqu'une séquence erronée d'impulsions différentielles successives est identifiée, toutes les valeurs des impulsions différentielles de la séquence erronée d'impulsions différentielles successives soient mises à zéro, et ce, quelle que soit la longueur de ladite séquence.

## Revendications

1. Procédé de comptage de tours d'une roue (6) sur laquelle est fixée une cible (7), le procédé de comptage comportant les étapes, répétées à intervalles de détection réguliers :
- de générer un signal de tension oscillant (S1, S2) représentatif de la présence ou de l'absence de la cible (7) ;
- de comparer une amplitude du signal de tension oscillant avec un seuil de tension prédéterminé (Vcc/2) pour obtenir des impulsions (19) ;
- de détecter une présence de la cible (7) ou une absence de la cible en fonction du nombre d'impulsions obtenues,
**caractérisé en ce que** le procédé de comptage comporte en outre une étape de détection d'une perturbation susceptible d'affecter une détection de la cible (7), l'étape de détection étant mise en œuvre de manière rétroactive et consistant à acquérir des valeurs d'impulsions différentielles égales chacune à une différence entre deux nombres d'impulsions obtenues au cours de deux intervalles de détection successifs, et à détecter une perturbation à partir d'une identification d'une séquence erronée d'impulsions différentielles successives.

2. Procédé de comptage selon la revendication 1, dans lequel une séquence donnée est identifiée comme étant une séquence erronée d'impulsions différentielles successives lorsque :
- une somme des valeurs des impulsions différentielles qui constituent la séquence donnée est nulle, et
- des bornes de la séquence donnée sont non nulles, et
- des impulsions différentielles extérieures à la séquence donnée et adjacentes aux bornes de la séquence donnée sont nulles.

3. Procédé de comptage selon la revendication 2, dans lequel une séquence donnée est identifiée comme étant une séquence erronée d'impulsions différentielles successives uniquement si la séquence donnée comporte au plus une impulsion différentielle nulle.

4. Procédé de comptage selon la revendication 1, dans lequel, lorsqu'une séquence erronée d'impulsions différentielles successives est identifiée, les valeurs des impulsions différentielles de la séquence erronée d'impulsions différentielles successives sont mises à zéro.

5. Procédé de comptage selon la revendication 1, comportant en outre une étape de détection de rotation effective consistant à détecter une rotation effective de la roue (6) en analysant la séquence erronée d'impulsions différentielles successives.

6. Procédé de comptage selon la revendication 5, dans lequel l'étape de détection de rotation effective consiste, pour une séquence erronée d'impulsions différentielles successives donnée :
- à classer dans une première catégorie les impulsions différentielles ayant une valeur absolue supérieure ou égale à un premier seuil de valeur prédéterminé ;
- à classer dans une deuxième catégorie les impulsions différentielles ayant une valeur absolue supérieure ou égale à un deuxième seuil de valeur prédéterminé, le deuxième seuil de valeur prédéterminé étant inférieur au premier seuil de valeur prédéterminé ;
- à classer dans une troisième catégorie les impulsions différentielles ayant une valeur absolue inférieure ou égale à un troisième seuil de valeur prédéterminé, le troisième seuil de valeur prédéterminé étant inférieur au deuxième seuil de valeur prédéterminé ;
- parmi les impulsions différentielles de la première catégorie et de la deuxième catégorie, à identifier des impulsions différentielles valides qui sont de signes contraires et qui sont séparées, dans la séquence erronée, par au moins deux impulsions différentielles successives.

7. Procédé de comptage selon la revendication 6, dans lequel les impulsions différentielles valides de la séquence erronée d'impulsions différentielles successives sont mises à une valeur différentielle prédéterminée, et dans lequel les autres impulsions différentielles de la séquence erronée d'impulsions différentielles successives sont mises à zéro.

8. Procédé de comptage selon la revendication 7, dans lequel la valeur différentielle prédéterminée est positive lorsque l'impulsion différentielle valide est positive et la valeur différentielle prédéterminée est négative lorsque l'impulsion différentielle valide est négative.

9. Procédé de comptage selon la revendication 5, dans lequel l'étape de détection de rotation effective est mise en œuvre seulement si une vitesse de rotation de la roue (6) est supérieure à un seuil de vitesse prédéterminé.

10. Procédé de comptage selon l'une des revendications précédentes, dans lequel la roue (6) est en matériau non métallique, la cible (7) est une masse métallique, le procédé de comptage étant mis en œuvre par un dispositif de détection et par une unité de comptage (18) reliée au dispositif de détection, le dispositif de détection comprenant un circuit inductif (10.1, 10.2) ayant une bobine (1.1, 1.2) montée fixe en regard d'une portion de trajectoire de la cible (7), l'unité de comptage (18) étant adaptée à émettre périodiquement en entrée du circuit inductif une impulsion de tension d'amplitude prédéterminée de manière à générer le signal de tension oscillant en sortie du circuit inductif.

11. Procédé de comptage selon la revendication 10, le procédé étant mis en œuvre par deux dispositifs de détection reliés chacun à l'unité de comptage (18), l'étape de détection de la perturbation étant réalisée par chaque dispositif de détection de manière indépendante.

12. Compteur comprenant une roue et un dispositif de comptage comportant :
- une cible (7) fixée sur la roue ;
- des moyens agencés pour générer un signal de tension oscillant (S1, S2) représentatif de la présence ou de l'absence de la cible (7) ;
- des moyens agencés pour comparer une amplitude du signal de tension oscillant avec un seuil de tension prédéterminé (Vcc/2) pour obtenir des impulsions (19) ;
- des moyens agencés pour détecter une présence de la cible (7) ou une absence de la cible en fonction du nombre d'impulsions obtenues, le dispositif de comptage du compteur étant adapté à mettre en œuvre le procédé de comptage selon la revendication 1.

13. Programme d'ordinateur comprenant des instructions pour mettre en œuvre, par un dispositif de comptage d'un compteur, le procédé de comptage selon la revendication 1, le compteur comprenant une roue et le dispositif de comptage, le dispositif de comptage comportant :
- une cible (7) fixée sur la roue ;
- des moyens agencés pour générer un signal de tension oscillant (S1, S2) représentatif de la présence ou de l'absence de la cible (7) ;
- des moyens agencés pour comparer une amplitude du signal de tension oscillant avec un seuil de tension prédéterminé (Vcc/2) pour obtenir des impulsions (19) ;
- des moyens agencés pour détecter une présence de la cible (7) ou une absence de la cible en fonction du nombre d'impulsions obtenues.

14. Moyens de stockage, **caractérisés en ce qu'**ils stockent un programme d'ordinateur selon la revendication 13.

## Patentansprüche

1. Verfahren zum Zählen von Umdrehungen eines Rades (6), an dem ein Ziel (7) befestigt ist, wobei das Zählverfahren die Schritte umfasst, die in regelmäßigen Detektionsintervallen wiederholt werden:
- Erzeugen eines oszillierenden Spannungssignals (S1, S2), das repräsentativ für das Vorhandensein oder das Nichtvorhandensein des Ziels (7) ist;
- Vergleichen einer Amplitude des oszillierenden Spannungssignals mit einem vorbestimmten Spannungsschwellenwert (Vcc/2), um Impulse (19) zu erhalten;
- Erfassen eines Vorhandenseins des Ziels (7) oder eines Nichtvorhandenseins des Ziels in Abhängigkeit von der Anzahl der erhaltenen Impulse; **dadurch gekennzeichnet, dass** das Zählverfahren ferner einen Detektionsschritt zum Erfassen einer Störung umfasst, die geeignet ist, eine Erfassung des Ziels (7) zu beeinträchtigen, wobei der Detektionsschritt retroaktiv durchgeführt wird und darin besteht, Werte von differentiellen Impulsen zu erfassen, die jeweils gleich einer Differenz zwischen zwei erhaltenen Impulszahlen sind, die während zweier aufeinanderfolgender Detektionsintervalle erhalten werden, und eine Störung anhand einer Identifizierung einer fehlerhaften Folge von aufeinanderfolgenden differentiellen Impulsen zu erfassen.

2. Zählverfahren nach Anspruch 1, bei dem eine gegebene Folge als eine fehlerhafte Folge von aufeinanderfolgenden differentiellen Impulsen identifiziert wird, wenn:
- eine Summe der Werte der differentiellen Impulse, die die gegebene Folge bilden, Null ist, und
- Grenzen der gegebenen Folge nicht Null sind, und
- differentielle Impulse außerhalb der gegebenen Folge und angrenzend an die Grenzen der gegebenen Folge Null sind.

3. Zählverfahren nach Anspruch 2, bei dem eine gegebene Folge nur als fehlerhafte Folge von aufeinanderfolgenden differentiellen Impulsen identifiziert wird, wenn die gegebene Folge höchstens einen differentiellen Impuls von Null hat.

4. Zählverfahren nach Anspruch 1, bei dem, wenn eine fehlerhafte Folge von aufeinanderfolgenden differentiellen Impulsen identifiziert wird, die Werte der differentiellen Impulse der fehlerhaften Folge von aufeinanderfolgenden differentiellen Impulsen auf Null gesetzt werden.

5. Zählverfahren nach Anspruch 1, ferner umfassend einen Detektionsschritt zum Erfassen einer tatsächlichen Drehung, der darin besteht, eine tatsächliche Drehung des Rades (6) zu erfassen, indem die fehlerhafte Folge von aufeinanderfolgenden differentiellen Impulsen analysiert wird.

6. Zählverfahren nach Anspruch 5, bei dem der Detektionsschritt zum Erfassen einer tatsächlichen Drehung für eine gegebene fehlerhafte Folge von aufeinanderfolgenden differentiellen Impulsen darin besteht:
- die differentiellen Impulse, die einen Absolutwert von größer oder gleich einem ersten vorbestimmten Schwellenwert haben, einer ersten Kategorie zuzuordnen;
- die differentiellen Impulse, die einen Absolutwert von größer oder gleich einem zweiten vorbestimmten Schwellenwert haben, wobei der zweite vorbestimmte Schwellenwert kleiner als der erste vorbestimmte Schwellenwert ist, einer zweiten Kategorie zuzuordnen;
- die differentiellen Impulse, die einen Absolutwert von kleiner oder gleich einem dritten vorbestimmten Schwellenwert haben, wobei der dritte vorbestimmte Schwellenwert kleiner als der zweite vorbestimmte Schwellenwert ist, einer dritten Kategorie zuzuordnen;
- unter den differentiellen Impulsen der ersten Kategorie und der zweiten Kategorie, Identifizieren gültiger differentieller Impulse, die entgegengesetzte Vorzeichen haben und die in der fehlerhaften Folge durch mindestens zwei aufeinanderfolgende differentielle Impulse getrennt sind.

7. Zählverfahren nach Anspruch 6, bei dem die gültigen differentiellen Impulse der fehlerhaften Folge von aufeinanderfolgenden differentiellen Impulsen auf einen vorbestimmten differentiellen Wert gesetzt werden, und bei dem die anderen differentiellen Impulse der fehlerhaften Folge von aufeinanderfolgenden differentiellen Impulsen auf Null gesetzt werden.

8. Zählverfahren nach Anspruch 7, bei dem der vorbestimmte differentielle Wert positiv ist, wenn der gültige differentielle Impuls positiv ist, und der vorbestimmte differentielle Wert negativ ist, wenn der gültige differentielle Impuls negativ ist.

9. Zählverfahren nach Anspruch 5, bei dem der Detektionsschritt zum Erfassen der tatsächlichen Drehung nur durchgeführt wird, wenn eine Drehgeschwindigkeit des Rades (6) größer als ein vorbestimmter Geschwindigkeitsschwellenwert ist.

10. Zählverfahren nach einem der vorhergehenden Ansprüche, bei dem das Rad (6) aus nicht metallischem Material ist, das Ziel (7) aus einer metallischen Masse ist, wobei das Zählverfahren von einer Detektionsvorrichtung und von einer mit der Detektionsvorrichtung verbundenen Zähleinheit (18) durchgeführt wird, wobei die Detektionsvorrichtung eine induktive Schaltung (10.1, 10.2) umfasst, die eine Spule (1.1, 1.2) hat, die ortsfest gegenüber einem Bahnabschnitt des Ziels (7) montiert ist, wobei die Zähleinheit (18) dazu geeignet ist, am Eingang der induktiven Schaltung periodisch einen Spannungsimpuls vorbestimmter Amplitude derart zu senden, dass das oszillierende Spannungssignal am Ausgang der induktiven Schaltung erzeugt wird.

11. Zählverfahren nach Anspruch 10, wobei das Verfahren von zwei Detektionsvorrichtungen durchgeführt wird, die jeweils mit der Zähleinheit (18) verbunden sind, wobei der Detektionsschritt zum Erfassen der Störung von jeder Detektionsvorrichtung auf unabhängige Weise ausgeführt wird.

12. Zähler, umfassend ein Rad und eine Zählvorrichtung, enthaltend:
- ein Ziel (7), das an dem Rad befestigt ist;
- Mittel, die ausgebildet sind, um ein oszillierendes Spannungssignal (S1, S2) zu erzeugen, das repräsentativ für das Vorhandensein oder das Nichtvorhandensein des Ziels (7) ist;
- Mittel, die ausgebildet sind, um eine Amplitude des oszillierenden Spannungssignals mit einem vorbestimmten Spannungsschwellenwert (Vcc/2) zu vergleichen, um Impulse (19) zu erhalten;
- Mittel, die ausgebildet sind, um ein Vorhandensein des Ziels (7) oder ein Nichtvorhandensein des Ziels in Abhängigkeit der Anzahl an erhaltenen Impulsen zu erfassen,
wobei die Zählvorrichtung des Zählers dazu geeignet ist, das Zählverfahren nach Anspruch 1 durchzuführen.

13. Computerprogramm, umfassend Anweisungen zum Durchführen des Zählverfahrens nach Anspruch 1 durch eine Zählvorrichtung eines Zählers, wobei der Zähler ein Rad und die Zählvorrichtung umfasst, wobei die Zählvorrichtung enthält:
- ein Ziel (7), das an dem Rad befestigt ist;
- Mittel, die ausgebildet sind, um ein oszillierendes Spannungssignal (S1, S2) zu erzeugen, das repräsentativ für das Vorhandensein oder das Nichtvorhandensein des Ziels (7) ist;
- Mittel, die ausgebildet sind, um eine Amplitude des oszillierenden Spannungssignals mit einem vorbestimmten Spannungsschwellenwert (Vcc/2) zu vergleichen, um Impulse (19) zu erhalten;
- Mittel, die ausgebildet sind, um ein Vorhandensein des Ziels (7) oder ein Nichtvorhandensein des Ziels in Abhängigkeit der Anzahl an erhaltenen Impulsen zu erfassen.

14. Speichermittel, **dadurch gekennzeichnet, dass** sie ein Computerprogramm nach Anspruch 13 speichern.

## Claims

1. A counting method for counting revolutions of a wheel (6) on which a target (7) is secured, the counting method comprising the following steps repeated at regular detection intervals:
- generating an oscillating voltage signal (S1, S2) representative of the presence or the absence of the target (7);
- comparing an amplitude of the oscillating voltage signal with a predetermined voltage threshold (Vcc/2) in order to obtain pulses (19); and
- detecting presence of the target (7) or absence of the target as a function of the number of pulses obtained,
the counting method being **characterized in that** it further comprises a step of detecting a disturbance that might affect detection of the target (7), the detection step being performed retroactively and consisting in acquiring differential pulse values, each equal to a difference between two numbers of pulses obtained during two successive detection intervals, and in detecting a disturbance by identifying an erroneous sequence of successive differential pulses.

2. A counting method according to claim 1, wherein a given sequence is identified as being an erroneous sequence of successive differential pulses when:
- the sum of the values of differential pulses constituting the given sequence is zero; and
- bounds of the given sequence are not zero; and
- differential pulses outside the given sequence and adjacent to the bounds of the given sequence are zero.

3. A counting method according to claim 2, wherein a given sequence is identified as being an erroneous sequence of successive differential pulses only if the given sequence has at most one zero differential pulse.

4. A counting method according to claim 1, wherein, when an erroneous sequence of successive differential pulses is identified, the values of the differential pulses of the erroneous sequence of successive differential pulses are set to zero.

5. A counting method according to claim 1, further comprising a step of detecting actual turning, which step consists in detecting actual turning of the wheel (6) by analyzing the erroneous sequence of successive differential pulses.

6. A counting method according to claim 5, wherein, for a given erroneous sequence of successive differential pulses, the step of detecting actual turning consists in:
- classifying differential pulses having an absolute value that is greater than or equal to a first predetermined threshold value in a first category;
- classifying differential pulses having an absolute value that is greater than or equal to a second predetermined threshold value, when the second predetermined threshold value is less than the first predetermined threshold value, in a second category;
- classifying differential pulses having an absolute value that is less than or equal to a third predetermined threshold value, when the third predetermined threshold value is less than the second predetermined threshold value, in a third category; and
- from among the differential pulses in the first category and in second category, identifying valid differential pulses, which are pulses of opposite signs that are separated in the erroneous sequence by at least two successive differential pulses.

7. A counting method according to claim 6, wherein the valid differential pulses of the erroneous sequence of successive differential pulses are set to a predetermined differential value, and wherein the other differential pulses of the erroneous sequence of successive differential pulses are set to zero.

8. A counting method according to claim 7, wherein the predetermined differential value is positive when the valid differential pulse is positive and the predetermined differential value is negative when the valid differential pulse is negative.

9. A counting method according to claim 5, wherein the step of detecting actual turning is performed only if the wheel (6) has a speed of rotation greater than a predetermined speed threshold.

10. A counting method according to any preceding claim, wherein the wheel (6) is made of non-metallic material, the target (7) is a metal mass, the counting method is performed by a detector device and by a counter unit (18) connected to the detector device, the detector device comprising an inductive circuit (10.1, 10.2) having a coil (1.1, 1.2) mounted stationary facing a portion of the path followed by the target (7), the counter unit (18) being adapted to transmit a voltage pulse of predetermined amplitude as input to the inductive circuit so as to generate an oscillating voltage signal as output from the inductive circuit.

11. A counting method according to claim 10, the method being performed by two detector devices, each connected to the counter unit (18), the step of detecting disturbance being performed by each detector device in independent manner.

12. A meter comprising a wheel and a counter device, the meter comprising:
- a target (7) secured to the wheel;
- means arranged to generate an oscillating voltage signal (S1, S2) representative of the presence or the absence of the target (7);
- means arranged to compare the amplitude of the oscillating voltage signal with a predetermined voltage threshold (Vcc/2) in order to obtain pulses (19); and
- means arranged to detect presence of the target (7) or absence of the target as a function of the number of pulses obtained;
the counter device of the meter being adapted to perform the counting method according to claim 1.

13. A computer program including instructions to enable a counter device of a meter to perform the counting method according to claim 1, the meter comprising a wheel and the counter device, the counter device comprising:
- a target (7) secured to the wheel;
- means arranged to generate an oscillating voltage signal (S1, S2) representative of the presence or the absence of the target (7);
- means arranged to compare the amplitude of the oscillating voltage signal with a predetermined voltage threshold (Vcc/2) in order to obtain pulses (19); and
- means arranged to detect presence of the target (7) or absence of the target as a function of the number of pulses obtained.

14. Storage means, **characterized in that** they store a computer program according to claim 13.
